# EUROPEAN PATENT SPECIFICATION

(11) **EP 2 144 370 B1**
(45) Date of publication and mention of the grant of the patent: **01.02.2012**
(21) Application number: 08012269.0
(22) Date of filing: 08.07.2008
(51) Int. Cl.: H03J 3/20, H03L 7/081

(54) **Oscillator phase noise reduction by self tuning filter and noise feedback**
Oszillator-Phasenrauschverringerung durch Selbsteinstellung der Filter- und Rauschrückmeldung
Réduction de bruit de phase d'oscillateur par un réglage automatique du filtre et réponse sonore

(43) Date of publication of application: 13.01.2010
(73) Proprietor: Sand 9, Inc., Boston, MA 02215 (US)
(72) Inventor: Brenndoerfer, Knut, 89134 Blaustein (DE)
(74) Representative: HOFFMANN EITLE

(56) References cited:
- DE-A1-102006 052 873
- DE-B3-102005 024 624
- US-A1- 2007 109 061
- US-B1- 6 420 916

## Description

### FIELD OF INVENTION

The present invention consists of 2 methods to reduce the far-out and close-in phase noise of a reference oscillator. More specifically the present invention contains a self tuning filter for far-out phase noise reduction and a group delay based feedback to reduce close in phase noise of an oscillator.

### BACKGROUND OF THE INVENTION

Today's high speed communication systems and RADAR systems require very low phase noise signal sources which by itself need low phase noise references.

Today's low noise references are usually based on Quartz crystals, SAW, MEMS, NEMS, BAW or FBAR resonators and the close-in and far-out phase noise has to be compromised as dictated by the power handling capabilities of the resonator and the noise generated in the oscillator itself due to the currents in the oscillator circuit. Filters based on the same type of resonators are used but suffer from different temperature drift and aging due to being a resonator different to the one used in the oscillator and manufacturing tolerances which are causing an offset between the oscillator frequency and the center frequency of the filter. This results in an unwanted non-symmetrical shape of the phase noise curve of the oscillator.

In addition the differences in the aging of the 2 resonators will cause the filter curve to further deviate from each other thus further increasing the offsets in the phase noise shape.

Potential differences in the temperature and aging characteristics of the two resonators can cause offsets in the shape of the phase noise curve as well.

DE 10 2005 024 624 B3 describes a circuit for generating a reference signal, in which a quartz oscillator is connected to a phase controlled band-pass filter, which outputs a stable low-noise reference signal. The phase controlled filter comprises a quartz filter with variable middle frequency, which is held at a constant transmission phase by a PLL connected between the output and input of the phase controlled filter. Similar circuits are known from DE 10 2006 052 873 A1 and US 6,420,916.

US 2007/0109061 A1 describes a voltage controlled oscillator that provides multi-octave band tenability. A multi-mode coupled resonator network is capacitively coupled across the base and collector terminal of a 3-terminal active device. A phase compensating network, which is capacitively coupled between the base terminal and resonators coupled to the collector, optimizes group delay dynamically for uniform and minimum pase noise performance.

### SUMMERY OF THE PRESENT INVENTION

It is an object of the present invention to reduce the phase noise of an oscillator by filtering the signal with a self tuning filter to reduce the far out phase noise. This object is achieved by the subject-matter of the independent claims. Advantageous embodiments are described in dependent claims.

The self tuning of the filter eliminates adjustments in production and keeps the filter centered to the oscillator frequency independent of aging, temperature characteristic and manufacturing tolerances of the resonator(s) used in the noise shaping filter.

The present invention is based on the principle that a resonator equal or similar to the one used in an oscillator has a very narrow passband thus filtering the noise generated in the oscillator. The resonator will change the angle of the phase between the input of the filter and its output in a way which can be detected and converted into a tuning voltage by means of a Phase Locked Loop circuit (PLL, analog or digital). Whenever the oscillator frequency or the center frequency of the filter changes a phase offset is generated, detected by the PLL and used to tune the filter back to be centered to the oscillator frequency.

The delay time caused by the filter is used as a delay line and the filtered output is used to generate a feedback signal to reduce the close in phase noise of the oscillator circuit.

Characteristic features of the present invention are in detail presented in the enclosed claims.

The main advantage of the methods presented in the present invention is that it significantly reduces close-in and/or far out phase noise without a requirement for additional tuning in manufacturing well below levels achievable with prior art methods.

### BRIEF DESCRIPTION OF DRAWINGS

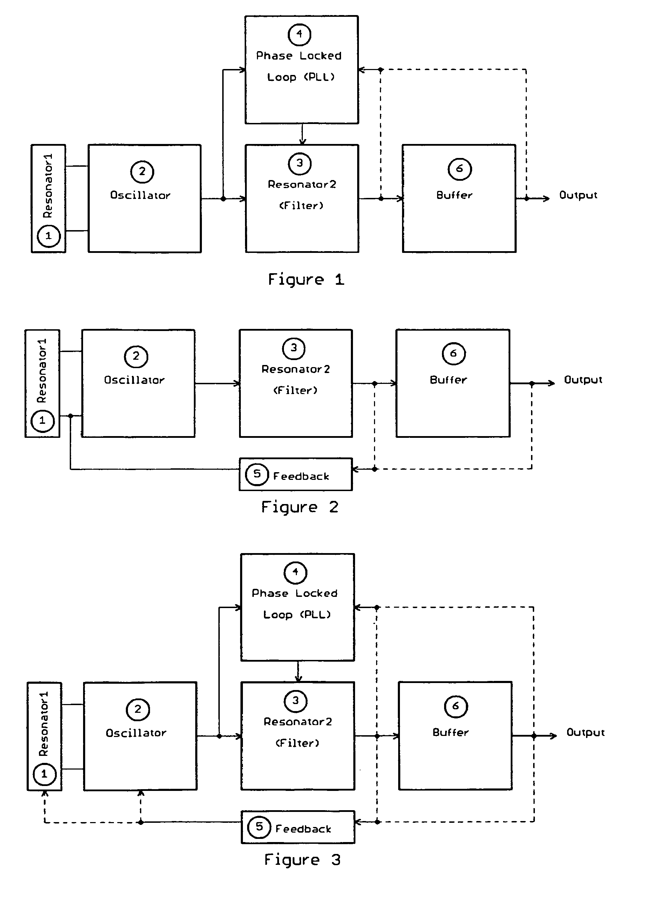

Figure 1:
   an oscillator with a Quartz crystals, SAW, MEMS, NEMS, BAW or FBAR resonator generates the desired frequency. The output is fed into a filter which contains the same or a similar type Quartz crystals, SAW, MEMS, NEMS, BAW or FBAR resonator on the same frequency as the oscillator itself. The filter is tuned to be exactly on the same frequency as the oscillator by means of a PLL circuit which monitors the phase shift between input and output of the filter and keeps it on the same value by means of feedback into a tuning element incorporated in the filter.
Figure 2:
   an oscillator and filter as in Figure 1 without the self tuning circuit where the filter generates a group delay. The delayed signal is fed back into the oscillator circuit to reduce the phase noise.
Figure 3:
   a combination of the circuits in Figure 1 and 2 which allows reduction of close-in and far-out phase noise in accordance with the claimed invention.

### DETAILED DESCRIPTION OF THE INVENTION

The present description relates to a method to reduce the phase noise of oscillators designed with Quartz crystals, SAW, MEMS, NEMS, BAW or FBAR resonator(s). It either can reduce the far-out noise alone (filter only) or both far-out and close-in phase noise.

Far out phase noise reduction is accomplished by means of a filter circuit which is designed with the same or similar type of Quartz crystals, SAW, MEMS, NEMS, BAW or FBAR resonator(s) as used for the oscillator (Figure 1). Having a very narrow pass band due to the high inherent Q of the resonator the filter bandwidth is very narrow thus capable of reducing the phase noise starting from a very low offset from the carrier. A major problem in this case is that the center frequency of such filter may be slightly off the oscillator frequency due to manufacturing or circuit tolerances and may shift off by exposure to temperature and by aging and other influences which in turn will alter the shape and/or frequency response of the passband curve up to the point where the desired signal might be reduced in amplitude. A Phase Locked Loop (PLL) circuit monitors the phase difference between input and output of the filter and derives a tuning signal to center the filter. This PLL circuit can either be of an analog or digital type circuit.

It is advantageous for the PLL that such a narrow filter will have a significant group delay time which means it causes a steep phase change versus frequency.

The delayed output signal can be used to reduce the close-in phase noise of the oscillator (Figure 2). This method is based on the idea how to measure phase noise with a delay line and uses the derived phase noise information to counteract the noise generated in the oscillator circuit itself.

As a side effect the PLL keeps the output signal of the filter in a constant phase relation to the oscillator signal which enables the use of injection lock technique to reduce the oscillator close in phase noise

The combination of the above methods in accordance with the claimed invention allows reduction of phase noise for both, close-in and far-out, without stringent requirements for tuning at the production stage (Figure 3).

## Claims

1. A device, comprising:
a resonator (1) and an oscillator (2);
a filter (3) coupled to the oscillator (2) to receive an output signal of the oscillator (2),
where the resonator (1) is of a particular type and where the filter (3) comprises a resonator of similar type;
a phase locked loop (4), PLL, coupled between an output of the filter (3) and an input of the filter (3) and configured to provide a tuning signal to the filter (3) to tune a center frequency of the filter (3); and
a feedback path (5) formed between the output of the filter and an input to the oscillator.

2. The device of claim 1, wherein the feedback path (5) is formed between the output of the filter (3) and an input to the resonator (1).

3. The device of claim 1 or 2, wherein the resonator (1) is of a particular type and wherein the filter (3) comprises a resonator of the same type.

4. The device of claim 3, wherein the resonator (1) is a microelectromechanical systems, MEMS, resonator and wherein the resonator of the filter (3) is a MEMS resonator.

5. The device of one of the preceding claims, further comprising a buffer (6) coupled to receive a filtered signal output by the filter (3), and wherein the feedback path (5) is formed between an output of the buffer (6) and an input of the oscillator (1).

6. A method of reducing noise of an oscillating signal, comprising:
producing an oscillating output signal with an oscillator (2);
filtering the oscillating output signal with a filter (3) to produce a filtered signal using a resonator of a similar type as a resonator (1) used to produce the oscillating output signal,
providing the oscillating output signal and the filtered signal to a phase locked loop, PLL, to maintain a constant phase difference between the oscillating output signal and the filtered signal by tuning the filer (3); and
providing the filtered signal as a feedback signal to the oscillator (2).

7. The method of claim 6, further comprising comparing a phase of the filtered signal to a phase of the oscillating output signal to determine a phase difference between them and produce a tuning signal to tune the filter based on the phase difference between the filtered signal and the oscillating output signal.

8. The method of claim 6 or 7, further comprising buffering the filtered signal to produce a buffered signal.

9. The method of claim 6, 7 or 8, wherein filtering the oscillating output signal with the filter comprises using the resonator of the same type as the resonator (1) used to produce the oscillating output signal.

## Patentansprüche

1. Vorrichtung, umfassend:
einen Resonator (1) und einen Oszillator (2);
ein Filter (3), das an den Oszillator (2) gekoppelt ist, um ein Ausgangssignal des Oszillators (2) zu empfangen,
wobei der Resonator (1) von einer bestimmten Art ist und der Filter (3) einen Resonator einer ähnlichen Art umfasst;
eine Phasenregelschleife (4), PLL, die zwischen einem Ausgang des Filters (3) und einem Eingang des Filters (3) gekoppelt ist und konfiguriert ist, ein Stimmsignal an das Filter (3) bereitzustellen, um eine Mittenfrequenz des Filters (3) zu stimmen; und
einen Rückkopplungspfad (5), der zwischen dem Ausgang des Filters und einem Eingang zu dem Oszillator gebildet ist.

2. Vorrichtung nach Anspruch 1, wobei der Rückkopplungspfad (5) zwischen dem Ausgang des Filters (3) und einem Eingang zu dem Resonator (1) gebildet ist.

3. Vorrichtung nach Anspruch 1 oder 2, wobei der Resonator (1) von einer bestimmten Art ist und wobei das Filter (3) einen Resonator derselben Art umfasst.

4. Vorrichtung nach Anspruch 3, wobei der Resonator (1) ein Mikro-Elektronik-Mechanisches-System-, MEMS, Resonator ist und wobei der Resonator des Filters (3) ein MEMS-Resonator ist.

5. Vorrichtung nach einem der vorangehenden Ansprüche, ferner umfassend einen Puffer (6), der gekoppelt ist um ein gefiltertes Signal zu empfangen, das von dem Filter (3) ausgegeben wird, und wobei der Rückkopplungspfad (5) zwischen einem Ausgang des Puffers (6) und einem Eingang zu dem Oszillator (1) gebildet ist.

6. Verfahren zum Reduzieren von Rauschen eines oszillierenden Signals, umfassend:
ein Erzeugen eines oszillierenden Ausgangssignals mit einem Oszillator (2);
ein Filtern des oszillierenden Ausgangssignals mit einem Filter (3) um ein gefiltertes Signal zu erzeugen unter Verwendung eines Resonators einer ähnlichen Art wie dem Resonator (1), der zum Erzeugen des oszillierenden Ausgangssignals verwendet wird;
ein Bereitstellen des oszillierenden Ausgangssignals und des gefilterten Signals an eine Phasenregelschleife, PLL, um eine konstante Phasendifferenz zwischen dem oszillierenden Ausgangssignal und dem gefilterten Signal zu erhalten, durch ein Stimmen des Filters (3); und
ein Bereitstellen des gefilterten Signals als ein Rückkopplungssignal an den Oszillator (2).

7. Verfahren nach Anspruch 6, ferner umfassend ein Vergleichen einer Phase des gefilterten Signals mit einer Phase des oszillierenden Ausgangssignals um eine Phasendifferenz zwischen ihnen zu bestimmen und ein Stimmsignal zu erzeugen um den Filter basierend auf der Phasendifferenz zwischen dem gefilterten Signal und dem oszillierenden Ausgangssignal zu stimmen.

8. Verfahren nach Anspruch 6 oder 7, ferner umfassend ein Puffern des gefilterten Signals um ein gepuffertes Signal zu erzeugen.

9. Verfahren nach Anspruch 6, 7 oder 8, wobei das Filtern des oszillierenden Ausgangssignals mit dem Filter ein Verwenden des Resonators derselben Art umfasst, wie dem Resonator (1), der verwendet wird um das oszillierende Ausgangssignal zu erzeugen.

## Revendications

1. Dispositif, comprenant :
un résonateur (1) et un oscillateur (2) ;
un filtre (3) couplé à l'oscillateur (2) pour recevoir un signal de sortie de l'oscillateur (2),
où le résonateur (1) est d'un type particulier et où le filtre (3) comprend un résonateur d'un type similaire ;
une boucle à verrouillage de phase (4), dite boucle PLL, couplée entre une sortie du filtre (3) et une entrée du filtre (3) et configurée pour fournir un signal de syntonisation au filtre (3) pour syntoniser une fréquence centrale du filtre (3), et
un chemin de rétroaction (5) formé entre la sortie du filtre et une entrée à l'oscillateur.

2. Dispositif de la revendication 1, où le chemin de rétroaction (5) est formé entre la sortie du filtre (3) et une entrée au résonateur (1).

3. Dispositif de la revendication 1 ou 2, où le résonateur (1) est d'un type particulier et où le filtre (3) comprend un résonateur du même type.

4. Dispositif de la revendication 3, où le résonateur (1) est un résonateur de systèmes micro-électromécaniques, MEMS, et où le résonateur du filtre (3) est un résonateur MEMS.

5. Dispositif de l'une des revendications précédentes, comprenant en outre une mémoire tampon (6) couplée pour recevoir une sortie de signal filtré par le filtre (3), et où le chemin de rétroaction (5) est formé entre une sortie de la mémoire tampon (6) et une entrée de l'oscillateur (1).

6. Procédé de réduction de bruit d'un signal oscillant, comprenant les étapes qui consistent à :
produire un signal de sortie oscillant avec un oscillateur (2) ;
filtrer le signal de sortie oscillant avec un filtre (3) pour produire un signal filtré en utilisant un résonateur d'un type similaire à un résonateur (1) utilisé pour produire le signal de sortie oscillant,
fournir le signal de sortie oscillant et le signal filtré à une boucle à verrouillage de phase, dite boucle PLL, afin de maintenir une différence de phase constante entre le signal de sortie oscillant et le signal filtré en syntonisant le filtre (3) ; et
fournir le signal filtré comme signal de rétroaction à l'oscillateur (2).

7. Procédé de la revendication 6, comprenant en outre le fait de comparer une phase du signal filtré à une phase du signal de sortie oscillant afin de déterminer une différence de phase entre eux et de produire un signal de syntonisation pour syntoniser le filtre sur la base de la différence de phase entre le signal filtré et le signal de sortie oscillant.

8. Procédé des revendications 6 ou 7, comprenant en outre la mise en mémoire tampon du signal filtré pour produire un signal en mémoire tampon.

9. Procédé des revendications 6, 7 ou 8, où le fait de filtrer le signal de sortie oscillant avec le filtre comprend l'utilisation du résonateur du même type que le résonateur (1) utilisé pour produire le signal de sortie oscillant.
